# EUROPEAN PATENT APPLICATION

(11) **EP 4 734 155 A1**
(43) Date of publication of application: **29.04.2026**
(21) Application number: 25183022.0
(22) Date of filing: 16.06.2025
(51) Int. Cl.: H01L 23/48, H01L 23/528, H01L 25/065, H10D 30/00

(54) **SEMICONDUCTOR DEVICE AND SEMICONDUCTOR PACKAGE INCLUDING THE SAME**

(30) Priority: 24.10.2024 KR 20240146630
(71) Applicant: Samsung Electronics Co., Ltd., Suwon-si, Gyeonggi-do 16677 (KR)
(72) Inventor: CHOI, Hojun, 16677 Suwon-si (KR); KIM, Jisoo, 16677 Suwon-si (KR); KIM, Jinkyu, 16677 Suwon-si (KR); BAE, Hyunjun, 16677 Suwon-si (KR); SEO, Jahyeong, 16677 Suwon-si (KR); JEONG, KyuTae, 16677 Suwon-si (KR); HAN, Dong-Hwan, 16677 Suwon-si (KR)
(74) Representative: Marks & Clerk LLP

(57) **Abstract**

An example semiconductor device includes a substrate having a first surface and a second surface opposite each other, a logic block provided on the first surface of the substrate, a power delivery network including power lines connected to the logic block on the second surface of the substrate, and a connection structure penetrating the substrate and connecting an upper chip pad and a lower chip pad, wherein at least one of the upper chip pad or the lower chip pad may vertically overlap the logic block, and the connection structure may include a through conductive pattern that is horizontally spaced apart from the logic block and penetrates the substrate.

## Description

### BACKGROUND

The present disclosure herein relates to a semiconductor device and a semiconductor package including the same.

Semiconductor devices include an integrated circuit configured with metal oxide semiconductor field-effect transistors (MOSFETs). As the size and design rule of semiconductor devices are reduced, scaling down ofMOSFETs are accelerated. The scaling down of MOSFETs may cause deterioration of operation characteristics of semiconductor devices. Therefore, researches are being carried out to develop various methods for manufacturing semiconductor devices having excellent performance while overcoming limitations due to high integration of semiconductor devices.

Furthermore, recently, as three-dimensional (3D) semiconductor packages for mounting a plurality of semiconductor chips in a single semiconductor package are actively developed, it is necessary to develop technology for ensuring electrical and mechanical reliability of a connection structure that penetrates a substrate or a die and vertically forms an electrical connection.

### SUMMARY

The present disclosure provides a semiconductor device with an improved degree of freedom of design and degree of integration and a semiconductor package including the same.

The purposes of the present disclosure are not limited to the above-mentioned purposes, and other purposes not mentioned would be clearly understood by those skilled in the art from the disclosure below.

According to some embodiments of the inventive concept, a semiconductor device includes a substrate having a first surface and a second surface opposite each other; a logic block provided on the first surface of the substrate; a power delivery network including power lines connected to the logic block on the second surface of the substrate; and a connection structure penetrating the substrate and connecting an upper chip pad and a lower chip pad, wherein at least one of the upper chip pad or the lower chip pad vertically overlaps the logic block, and the connection structure includes a through conductive pattern that is horizontally spaced apart from the logic block and penetrates the substrate.

According to some embodiments of the inventive concept, a semiconductor device includes: a substrate having a first surface and a second surface opposite each other; a logic block provided on the first surface of the substrate; an upper wiring line connected to the logic block on the first surface; a power delivery network including power lines connected to the logic block on the second surface; and a connection structure penetrating the substrate and connecting an upper chip pad and a lower chip pad, wherein at least one of the upper chip pad or the lower chip pad vertically overlaps the logic block, and the connection structure includes: a through conductive pattern that is horizontally spaced apart from the logic block and penetrates the substrate; an upper connection line provided on the first surface and vertically overlapping the through conductive pattern and the logic block; and a lower connection line provided on the second surface and vertically overlapping the through conductive pattern and the logic block.

According to some embodiments of the inventive concept, a semiconductor package includes: a redistribution substrate; a first semiconductor chip on the redistribution substrate; and a second semiconductor chip on the first semiconductor chip, wherein the first semiconductor chip includes: upper chip pads provided on an upper surface of the first semiconductor chip; lower chip pads provided on a lower surface of the first semiconductor chip; a logic block provided on a first surface of a substrate; an upper line connected to the logic block on the first surface of the substrate; a power delivery network provided on a second surface of the substrate and including power lines connected to the logic block; and a connection structure penetrating the substrate and connecting a first upper chip pad among the upper chip pads and a first lower chip pad among the lower chip pads. In an embodiment, the connection structure may include: a through conductive pattern horizontally spaced apart from the logic block and penetrating the substrate; upper connection lines connecting the through conductive pattern and the first upper chip pad on the first surface of the substrate; and lower connection lines connecting the through conductive pattern and the first lower chip pad on the second surface of the substrate, wherein the first upper chip pad and the first lower chip pad may vertically overlap the logic block.

Details about other embodiments are included in the detailed description and the drawings.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate example embodiments of the inventive concept and, together with the description, serve to explain principles of the inventive concept. In the drawings:
FIG. 1 is a cross-sectional view of a semiconductor package including a semiconductor device according to example embodiments of the inventive concept;
FIG. 2 is a plan view schematically illustrating a semiconductor package including a semiconductor device according to example embodiments of the inventive concept;
FIG. 3 is a cross-sectional view of a portion, which is the portion P1 of FIG. 1, of a semiconductor package including a semiconductor device according to example embodiments of the inventive concept;
FIG. 4 is a plan view of a portion, which is the portion P2 of FIG. 2, of a semiconductor device according to example embodiments of the inventive concept;
FIG. 5 is a cross-sectional view of a portion of a semiconductor device, taken along line A-A' of FIG. 4, according to example embodiments of the inventive concept;
FIGS. 6A, 6B, and 6C are schematic perspective view of a portion of a semiconductor device according to example embodiments of the inventive concept;
FIG. 7A, 7B, 7C, and 7D are perspective views for describing shapes of conductive patterns constituting a connection structure of a semiconductor device according to example embodiments of the inventive concept;
FIG. 8A, 8B, 8C, 8D, and 8E are perspective views for describing shapes of conductive vias constituting a connection structure of a semiconductor device according to example embodiments of the inventive concept;
FIG. 9 is a schematic plan view of a logic block provided to a portion of a semiconductor device according to example embodiments of the inventive concept;
FIG. 10 is a plan view of a portion of a semiconductor device according to example embodiments of the inventive concept;
FIG. 11 is a cross-sectional view, taken along line I-I' of FIG. 10, for describing a semiconductor device according to an example embodiment of the inventive concept;
FIG. 12 is a cross-sectional view of a semiconductor package including a semiconductor device according to example embodiments of the inventive concept; and
FIGS. 13 to 17 are diagrams illustrating a method for manufacturing a semiconductor package according to example embodiments of the inventive concept.

### DETAILED DESCRIPTION

Hereinafter, a semiconductor device and a semiconductor package including the same according to embodiments of the inventive concept will be described in detail with reference to the drawings. Like reference characters refer to like elements throughout.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise.

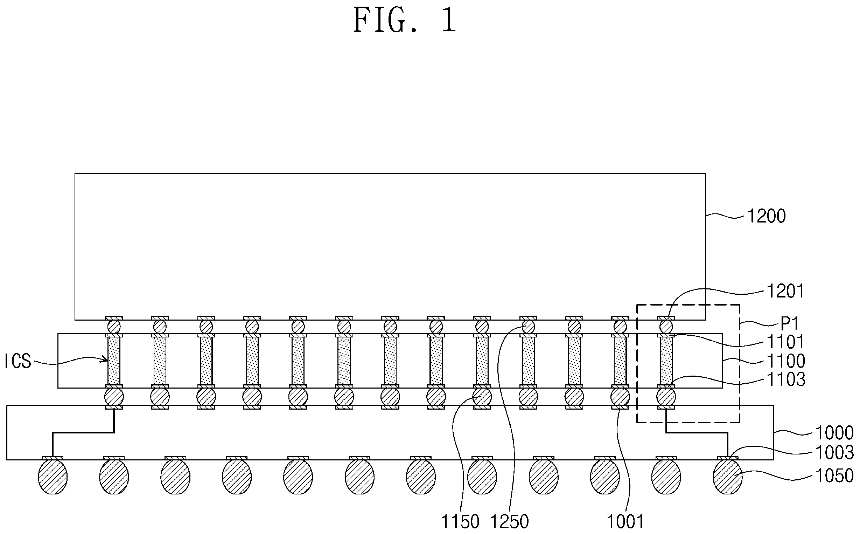

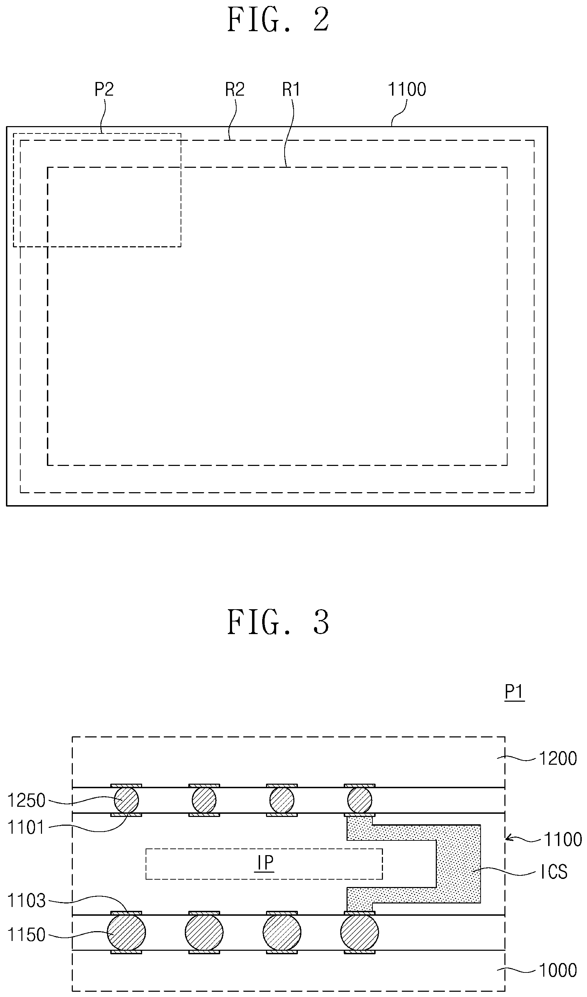

FIG. 1 is a cross-sectional view of a semiconductor package including a semiconductor device according to example embodiments of the inventive concept. FIG. 2 is a plan view schematically illustrating a semiconductor package including a semiconductor device according to example embodiments of the inventive concept. FIG. 3 is a cross-sectional view of a portion, which is the portion P1 of FIG. 1, of a semiconductor package including a semiconductor device according to example embodiments of the inventive concept.

Referring to FIG. 1, a semiconductor package may include a redistribution substrate 1000, a first semiconductor device 1100, and a second semiconductor device 1200.

The redistribution substrate 1000 may include upper connection pads 1001 on an upper surface of the redistribution substrate 1000 and lower connection pads 1003 on a lower surface of the redistribution substrate 1000. The redistribution substrate 1000 may include a plurality of base insulating layers and redistribution patterns. The redistribution patterns may include conductive line patterns on the base insulating layers and conductive vias vertically penetrating the base insulating layers.

First connection terminals 1050 may be attached to the lower connection pads 1003 of the redistribution substrate 1000. The first connection terminals 1050 may contact the lower connection pads 1003. The first connection terminals 1050 may be at least one of a solder ball, a conductive bump, or a conductive pillar. The first connection terminals 1050 may include at least one of copper, tin, or lead.

The semiconductor package may transmit/receive signals to/from external other packages or other semiconductor devices through the first connection terminals 1050. For example, a power (ground or power supply) signal for driving the first and second semiconductor devices 1100 and 1200 may be received through at least some of the first connection terminals 1050 of the redistribution substrate 1000.

The first semiconductor device 1100 may be mounted on the redistribution substrate 1000. The first semiconductor device 1100, for example, may be a logic chip including a process such as a micro electro mechanical (MEMS) device, an optoelectronic device, a central processing unit (CPU), a graphic processing unit (GPU), a mobile application processor, a digital signal processor (DSP), or the like.

The first semiconductor device 1100 may include the upper chip pads 1101 on the upper surface of the first semiconductor device 1100 and the lower chip pads 1103 on the lower surface of the first semiconductor device 1100, and may include connection structures ICS connecting the upper and lower chip pads 1101 and 1103. Some of the connection structures ICS may provide power signals from the redistribution substrate 1000 to the second semiconductor device 1200.

Referring to FIGS. 2 and 3, the first semiconductor device 1100 may include a center region R1 and an edge region R2 around the center region R1. The first semiconductor device 1100 may include logic blocks IP in both of the center region R1 and the edge region R2. The first semiconductor device 1100 may include the connection structures ICS in the edge region R2. For another example, the connection structures ICS may be arranged in a portion of the center region R1.

The logic blocks IP may be arrayed in a matrix form. The logic blocks IP may also be referred to as functional blocks, hard macros, or intellectual property (IP). The logic blocks IP may refer to reusable blocks implemented with a fixed layout and interconnection specified to perform a desired electrical function. For example, the logic blocks IP may include macro blocks for data processing and/or operation and memory blocks for storing data. The logic blocks IP may include a plurality of standard cells or logic cells. The standard cells may be a logic circuit (e.g., AND, OR, XOR, XNOR, inverter, etc.) for performing a specific function. That is, the standard cells may include transistors for constituting a logic element and lines for connecting the transistors to each other.

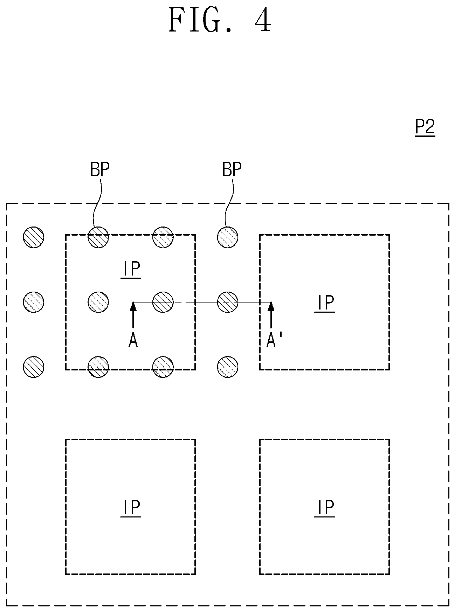

According to some embodiments, the connection structures ICS of the first semiconductor device 1100 may transfer a power (ground or power supply) signal from the redistribution substrate 1000 to the second semiconductor device 1200, and may detour around the logic blocks IP and connect the upper chip pad 1101 and the lower chip pad 1103. The connection structures ICS may include portions vertically overlapping portions of the logic blocks IP. For example, the connection structures ICS may include portions that overlap portions of the logic blocks IP in a direction perpendicular to both upper and lower surfaces of the first semiconductor device 1100. The connection structures ICS of the first semiconductor device 1100 will be described in more detail with reference to FIGS. 4 to 8E.

Second connection terminals 1150 may be provided between the upper connection pads 1001 of the redistribution substrate 1000 and the lower chip pads 1103 of the first semiconductor device 1100. The second connection terminals 1150 may contact both the upper connection pads 1001 and the lower chip pads 1103. The second connection terminals 1150 may be a solder ball or bump formed of tin, lead, copper, or the like.

For example, the second connection terminals 1150 may be smaller than the first connection terminals 1050. In example embodiments, a diameter of the second connection terminals 1150 may be smaller than a diameter of the first connection terminals 1050. For example, a volume of material of the second connection terminals 1150 may be smaller than a volume of material of the first connection terminals 1050.

The second semiconductor device 1200 may be mounted on the first semiconductor device 1100. The second semiconductor device 1200 may receive power and a signal from the redistribution substrate 1000 through the first semiconductor device 1100.

The second semiconductor device 1200 may be supplied with a power supply voltage from the redistribution substrate 1000 through first connection structures among the connection structures ICS in the first semiconductor device 1100, and may be supplied with a ground voltage from the redistribution substrate 1000 through second connection structures among the connection structures ICS. Furthermore, the second semiconductor device 1200 may exchange signals with the first semiconductor device 1100 through third connection structures among the connection structures ICS in the first semiconductor device 1100.

The second semiconductor device 1200 may be a single chip or a chip stack in which a plurality of chips are stacked. The second semiconductor device 1200 may include a memory cell array, a column decoder, a row decoder, a sense amplifier, a write driver, an input/output buffer, etc.

The first semiconductor device 1100 and the second semiconductor device 1200 may be connected to each other through third connection terminals 1250. For example, the third connection terminals 1250 may contact both the upper chip pads 1101 of the first semiconductor device 1100 and the lower chip pads 1201 of the second semiconductor device 1200. The third connection terminals 1250 may be a solder ball or bump formed of tin, lead, copper, or the like.

For example, the third connection terminals 1250 may be smaller than the second connection terminals 1150. In example embodiments, a diameter of the third connection terminals 1250 may be smaller than a diameter of the second connection terminals 1150. For example, a volume of material of the third connection terminals 1250 may be smaller than a volume of material of the second connection terminals 1150.

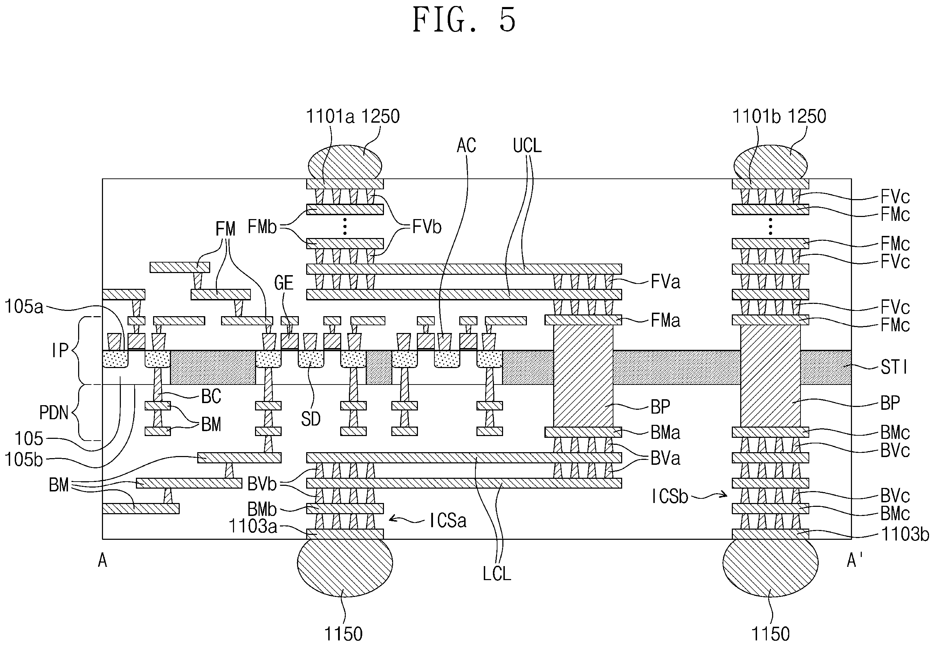

FIG. 4 is a plan view of a portion, which is the portion P2 of FIG. 2, of a semiconductor device according to example embodiments of the inventive concept. FIG. 5 is a cross-sectional view of a portion of a semiconductor device, taken along line A-A' of FIG. 4, according to example embodiments of the inventive concept.

Referring to FIGS. 4 and 5, the first semiconductor device 1100 may include a substrate 105, the logic blocks IP, a power delivery network or power distribution network PDN, and connection structures ICSa and ICSb connecting the upper chip pads 1101 and the lower chip pads 1103.

The upper chip pads 1101 may be arranged at regular intervals on an upper surface of the first semiconductor device 1100. Upper surfaces of the upper chip pads 1101 may be coplanar with the upper surface of the first semiconductor device 1100. The lower chip pads 1103 may be arranged at regular intervals on a lower surface of the first semiconductor device 1100. Lower surfaces of the lower chip pads 1103 may be coplanar with the lower surface of the first semiconductor device 1100. The upper and lower chip pads 1101 and 1103 may include, for example, at least one of tungsten (W), aluminum (Al), copper (Cu), tungsten nitride (WN), tantalum nitride (TaN), or titanium nitride (TiN).

The substrate 105 may have a first surface 105a and a second surface 105b opposite each other. The substrate 105 may include a silicon-based insulating layer. In other words, the substrate 105 may be a semiconductor substrate or insulating substrate. For example, the substrate 105 may include a silicon oxide layer, silicon nitride layer, or silicon oxynitride layer.

A device isolation layer STI defining active regions may be disposed in the substrate 105. The device isolation layer STI may be formed of, for example, an insulating material such as silicon oxide.

The logic blocks IP may be integrated on the first surface 105a of the substrate 105. The logic blocks IP may be an AND gate, OR gate, NOR gate, inverter, latch, or the like. Furthermore, the logic blocks IP may include field effect transistors, resistance element, and the like.

According to some embodiments, the logic blocks IP may include gate electrodes GE arranged on the first surface 105a and source/drain patterns SD in the substrate 105 on both sides of the gate electrodes GE. Active contacts AC may be electrically connected to the source/drain patterns SD.

Upper wiring lines FM may be connected to the logic blocks IP on the first surface 105a. The upper wiring lines FM may be electrically connected to the gate electrodes GE and the active contacts AC through contact plugs. The upper wiring lines FM may include a plurality of metal wiring lines stacked with interlayer insulating layers interposed therebetween, and the upper wiring lines FM of different layers may be electrically connected through contact plugs. The upper wiring lines FM may include clock lines for transferring a clock signal and signal lines for transferring a general signal.

The power delivery network PDN may be provided on the second surface 105b of the substrate 105. The power delivery network PDN may include a plurality of backside wiring lines BM stacked with interlayer insulating layers interposed therebetween. Some of the backside wiring lines BM may be power lines for delivering power supply voltage or ground voltage.

The power lines among the backside wiring lines BM may be electrically connected to the source/drain patterns SD through backside contacts BC. The backside contacts BC may have a diameter of about several nanometers to about several micrometers, for example. The backside contacts BC may have a vertical length of about several dozens of nanometers to about several micrometers, for example. Although not illustrated, an insulating layer (not shown) may be interposed between sidewalls of the backside contacts BC and the substrate 105. The backside wiring lines BM and the backside contacts BC may include a metal material, for example, W, WN, WC, Ti, TiN, Ta, TaN, Ru, Co, Mn, WN, Ni, or NiB.

According to some embodiments, the connection structures ICSa and ICSb may vertically penetrate the substrate 105, and may electrically connect the upper chip pads 1101 and the lower chip pads 1103. The connection structures ICSa and ICSb may connect the redistribution substrate 1000 (see FIG. 1) and the second semiconductor device 1200 (see FIG. 1). The connection structures ICSa and ICSb may deliver power or ground voltage from the redistribution substrate 1000 to the second semiconductor device 1200.

For example, the connection structures ICSa and ICSb may include a first connection structure ICSa connecting a first upper chip pad 1101a and a first lower chip pad 1103a and a second connection structure ICSb connecting a second upper chip pad 1101b and a second lower chip pad 1103b.

The first upper chip pad 1101a and the first lower chip pad 1103a may vertically overlap the logic blocks IP. The first upper chip pad 1101a may vertically overlap the first lower chip pad 1103a. The second upper chip pad 1101b and the second lower chip pad 1103b may not vertically overlap the logic blocks IP. The third connection terminals 1250 may be attached on the first and second upper chip pads 1101a and 1101b, and the second connection terminals 1150 may be attached on the first and second lower chip pads 1103a and 1103b. The third connection terminals 1250 may contact the first and second upper chip pads 1101a and 1101b, and the second connection terminals 1150 may contact the first and second lower chip pads 1103a and 1103b.

The first connection structure ICSa may include a through conductive pattern BP horizontally spaced apart from the logic blocks IP and penetrating the substrate 105, upper connection lines UCL, and lower connection lines LCL.

In addition, the first connection structure ICSa may further include first upper conductive patterns FMa and first upper conductive vias FVa alternately stacked between the upper connection lines UCL and the through conductive pattern BP and second upper conductive patterns FMb and second upper conductive vias FVb alternately stacked between the upper connection lines UCL and the first upper chip pad 1101a. In embodiments, a stacked number and stack level of the first upper conductive patterns FMa, the upper connection lines UCL, and the second upper conductive patterns FMb may be variously changed. Furthermore, shapes of the first upper conductive patterns FMa, the upper connection lines UCL, and the upper conductive patterns FMb may be variously changed to a rectangle, square, polygon, or the like in consideration of resistance of each pattern.

Furthermore, the first connection structure ICSa may further include first lower conductive patterns BMa and first lower conductive vias BVa alternately stacked between the lower connection lines LCL and the through conductive pattern BP and second lower conductive patterns BMb and second lower conductive vias BVb alternately stacked between the lower connection lines LCL and the first lower chip pad 1103a. A stacked number and stack level of the first lower conductive patterns BMa, the lower connection lines LCL, and the second lower conductive patterns BMb may be variously changed.

The through conductive pattern BP may have a larger vertical length than the backside contacts BC and have a larger diameter than the backside contacts BC. The through conductive pattern BP may have a diameter of about several dozens of nanometers to about several dozens of micrometers, for example. A lower surface of the through conductive pattern BP may be lower than lower surfaces of the backside contacts BC, and an upper surface of the through conductive pattern BP may be higher than the first surface 105a of the substrate 105. The through conductive pattern BP may include a metal material, for example, W, WN, WC, Ti, TiN, Ta, TaN, Ru, Co, Mn, WN, Ni, or NiB.

In embodiments, the upper connection lines UCL may be arranged on the first surface 105a of the substrate 105, and some of the upper connection lines UCL may be located at a farther distance from the first surface 105a than some of the upper wiring lines FM. Other some of the upper connection lines UCL may be located at the same level or same distance from the first surface 105a as other some of the upper wiring lines FM connected to the logic blocks IP.

The upper connection lines UCL may have a bar shape having a long axis in one direction. The upper connection lines UCL may vertically overlap the through conductive pattern BP and the logic blocks IP. The upper connection lines UCL may connect the through conductive pattern BP and the first upper chip pad 1101a.

In a horizontal direction, a length of the upper connection line UCL may be larger than a length of the first or second upper conductive patterns FMa or FMb. The upper connection lines UCL may be vertically stacked, and the first and second upper conductive vias FVa and FVb may be connected between the stacked upper connection lines UCL.

In embodiments, the lower connection lines LCL may be arranged on the second surface 105b of the substrate 105 and may vertically overlap the through conductive pattern BP and the logic blocks IP. Some of the lower connection lines LCL may be located at a farther distance from the second surface 105b than some of the backside wiring lines BM including power lines. Furthermore, other some of the lower connection lines LCL may be located at the same level or same distance from the second surface 105b as other some of the backside wiring lines BM connected to the logic blocks IP.

The lower connection lines LCL may connect the through conductive pattern BP and the first lower chip pad 1103a. The lower connection lines LCL may have a bar shape having a long axis in one direction. The lower connection lines LCL may be vertically stacked, and the first and second lower conductive vias BVa and BVb may be connected between the stacked lower connection lines LCL.

The second connection structure ICSb may be horizontally spaced apart from the first connection structure ICSa. The second connection structure ICSb may include the through conductive pattern BP penetrating the substrate 105, third upper conductive patterns FMc, third upper conductive vias FVc, third lower conductive patterns BMc, and third lower conductive vias BVc.

The third upper conductive patterns FMc and the third upper conductive vias FVc may be alternately stacked between the through conductive pattern BP and the second upper chip pad 1101b. The third lower conductive patterns BMc and the third lower conductive vias BVc may be alternately stacked between the through conductive pattern BP and the second lower chip pad 1103b.

The second upper and lower chip pads 1101b and 1103b may vertically overlap each other. The third upper conductive patterns FMc may vertically overlap the second upper chip pad 1101b, and the third lower conductive patterns BMc may vertically overlap the second lower chip pad 1103b.

Some of the third upper conductive patterns FMc may be located at substantially the same level as the upper wiring lines FM connected to the logic blocks IP. Some of the third lower conductive patterns BMc may be located at substantially the same level as the backside wiring lines BM including power lines connected to the logic blocks IP.

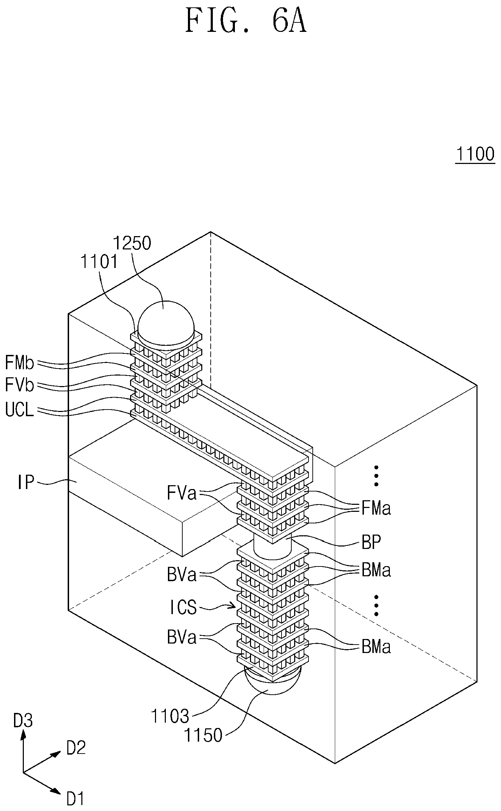

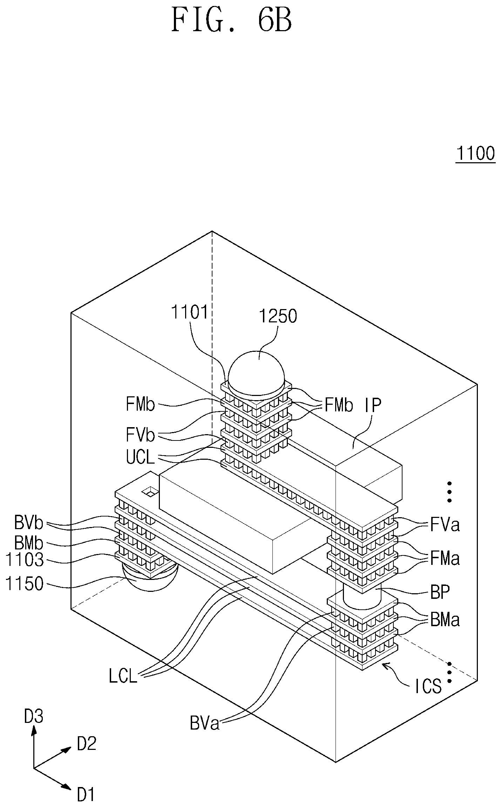

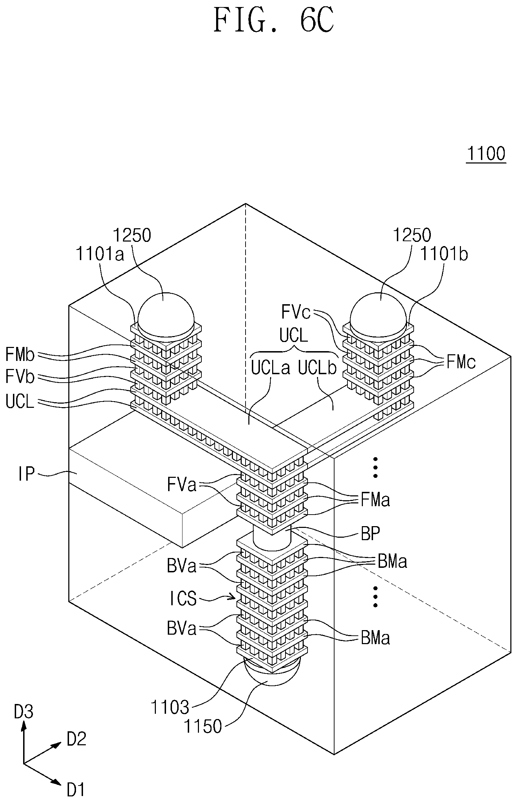

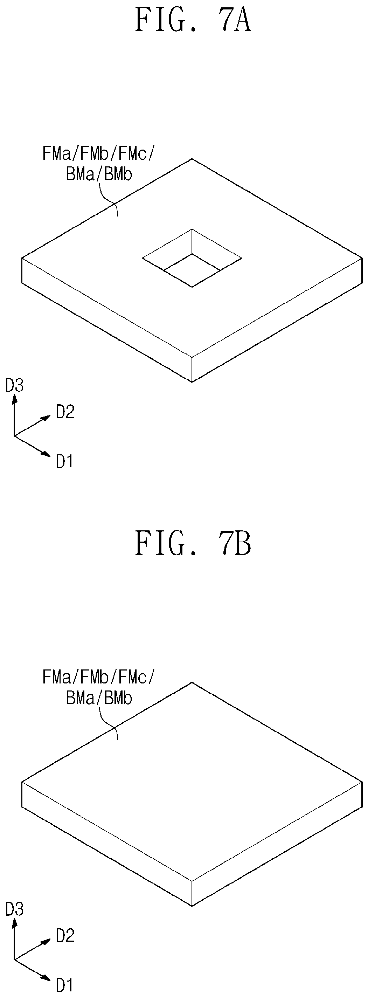

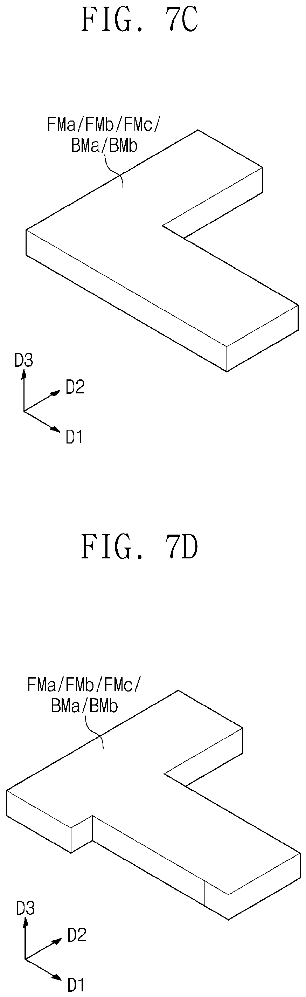

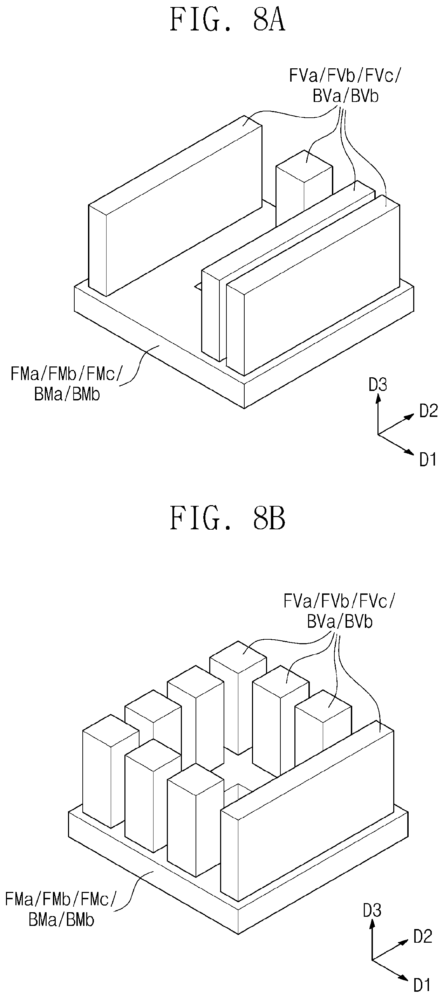

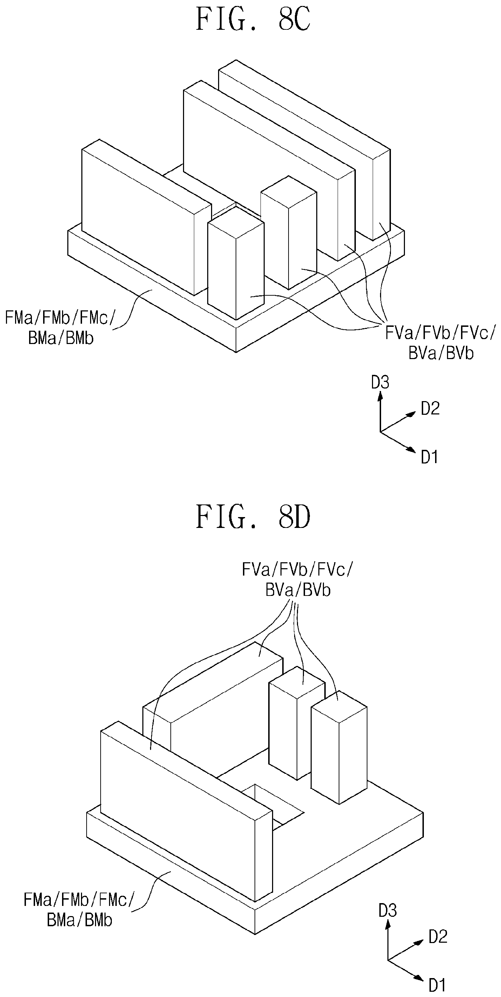

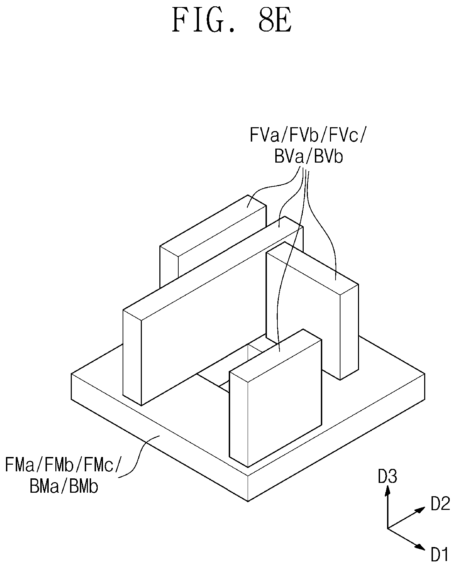

FIGS. 6A, 6B, and 6C are schematic perspective view of a portion of a semiconductor device according to example embodiments of the inventive concept. FIG. 7A, 7B, 7C, and 7D are perspective views for describing shapes of conductive patterns constituting a connection structure of a semiconductor device according to example embodiments of the inventive concept. FIG. 8A, 8B, 8C, 8D, and 8E are perspective views for describing shapes of conductive vias constituting a connection structure of a semiconductor device according to example embodiments of the inventive concept. For conciseness, descriptions of the same technical features as the embodiments described above with reference to FIGS. 1 to 5 may not be repeated.

Referring to FIGS. 6A and 6B, the first semiconductor device 1100 may include the upper chip pad 1101 provided on an upper surface of the first semiconductor device 1100, the lower chip pad 1103 provided on a lower surface of the first semiconductor device 1100, the logic block IP, and the connection structure ICS connecting the upper chip pad 1101 and the lower chip pad 1103.

Referring to FIG. 6A, as described above, the connection structure ICS may include the through conductive pattern BP vertically penetrating a substrate, the upper connection lines UCL, the first upper conductive patterns FMa, the first upper conductive vias FVa, the second upper conductive patterns FMb, the second upper conductive vias FVb, the first lower conductive patterns BMa, and the first lower conductive vias BVa.

For example, the upper chip pad 1101 and the lower chip pad 1103 may not vertically overlap each other. In other words, the upper chip pad 1101 and the lower chip pad 1103 may be positioned at different locations in a plan view.

The upper connection line UCL may extend from above the through conductive pattern BP to above the logic block IP. For example, the upper connection line UCL may vertically overlap the through conductive pattern BP and the logic block IP. In one direction, a length of the upper connection line UCL may be larger than a length of the first and second upper conductive patterns FMa and FMb.

The first upper conductive patterns FMa and the first upper conductive vias FVa may be vertically and alternately stacked between the upper connection line UCL and an upper surface of the through conductive pattern BP. The second upper conductive patterns FMb and the second upper conductive vias FVb may be vertically and alternately stacked between the upper connection line UCL and the upper chip pad 1101.

The first lower conductive patterns BMa may vertically overlap the through conductive pattern BP and the lower chip pad 1103. The through conductive pattern BP may be electrically connected to the lower chip pad 1103 through the first lower conductive patterns BMa and the first lower conductive vias BVa.

Referring to FIG. 6B, the connection structure ICS may include the through conductive pattern BP vertically penetrating a substrate, the upper connection lines UCL, the lower connection lines LCL, the first upper conductive patterns FMa, the first upper conductive vias FVa, the second upper conductive patterns FMb, the second upper conductive vias FVb, the first lower conductive patterns BMa, the first lower conductive vias BVa, the second lower conductive patterns BMb, and the second lower conductive vias BVb.

The connection structure ICS may electrically connect the upper chip pad 1101 and the lower chip pad 1103. For example, the upper chip pad 1101 may not vertically overlap the lower chip pad 1103. In other words, the upper chip pad 1101 and the lower chip pad 1103 may be positioned at different locations in a plan view.

The upper connection lines UCL may extend from above an upper surface of the through conductive pattern BP to above the logic block IP. The lower connection lines LCL may extend from above a lower surface of the through conductive pattern BP to above the logic block IP. The lower connection lines LCL may vertically overlap the upper connection lines UCL.

In one direction, a length of the upper connection line UCL may be different from a length of the lower connection line LCL. For example, the length of the lower connection line LCL may be larger than the length of the upper connection line UCL.

The first lower conductive patterns BMa and the first lower conductive vias BVa may be vertically and alternately stacked between the lower connection line LCL and a lower surface of the through conductive pattern BP. The second lower conductive patterns BMb and the second lower conductive vias BVb may be vertically and alternately stacked between the lower connection line LCL and the lower chip pad 1103.

Referring to FIG. 6C, the first semiconductor device 1100 may include the first and second upper chip pads 1101a and 1101b provided on an upper surface of the first semiconductor device 1100, the lower chip pad 1103 provided on a lower surface of the first semiconductor device 1100, the logic block IP, and the connection structure ICS connecting the first and second upper chip pads 1101a and 1101b and the lower chip pad 1103.

The first and second upper chip pads 1101a and 1101b may be spaced apart from each other, and at least one of the first or second upper chip pad 1101a or 1101b may vertically overlap the logic block IP. Furthermore, the first and second upper chip pads 1101a and 1101b may not vertically overlap the lower chip pad 1103.

The connection structure ICS may include the through conductive pattern BP vertically penetrating a substrate, the upper connection lines UCL, the first upper conductive patterns FMa, the first upper conductive vias FVa, the second upper conductive patterns FMb, the second upper conductive vias FVb, the third upper conductive patterns BMc, the third upper conductive vias FVc, the first lower conductive patterns BMa, and the first lower conductive vias BVa.

In detail, the upper connection lines UCL may each include a first portion UCLa extending in a first direction D1 and a second portion UCLb extending in a second direction D2 intersecting the first direction D1.

The first upper conductive patterns FMa and the first upper conductive vias FVa may be vertically and alternately stacked between an upper surface of the through conductive pattern BP and the upper connection lines UCL.

The second upper conductive patterns FMb and the second upper conductive vias FVb may be vertically and alternately stacked between the uppermost upper connection lines UCL and the first upper chip pad 1101a.

The third upper conductive patterns FMc and the third upper conductive vias FVc may be vertically and alternately stacked between the uppermost upper connection lines UCL and the second upper chip pad 1101b.

The first lower conductive patterns BMa and the first lower conductive vias BVa may be vertically and alternately stacked between a lower surface of the through conductive pattern BP and the lower chip pad 1103.

In the embodiments illustrated in FIGS. 6A, 6B, and 6C, the conductive patterns FMa, FMb, FMc, BMa, and BMb constituting the connection structure ICS may be variously changed in shape to a rectangle, square, polygon, or the like in consideration of a layout of each layer and resistance of each pattern. Furthermore, the conductive vias FVa, FVb, FVc, BVa, and BVb constituting the connection structure ICS may be changed in shape, arrangement, and number in consideration of a layout of each layer and resistance of each pattern.

For example, as illustrated in FIG. 7A, at least one of the conductive patterns FMa, FMb, FMc, BMa, and BMb may have a polygonal shape having an opening or hole in a center thereof. At least one of the conductive patterns FMa, FMb, FMc, BMa, and BMb may have a shape of a board as illustrated in FIG. 7B or may have a bracket shape or L shape as illustrated in FIG. 7C. Furthermore, at least one of the conductive patterns FMa, FMb, FMc, BMa, and BMb may have a T shape as illustrated in FIG. 7D.

For example, referring to FIGS. 8A to 8E, some of the conductive vias FVa, FVb, FVc, BVa, and BVb may have a bar shape having a long axis in one direction, and other some of the conductive vias may have a polygonal column shape.

As illustrated in FIG. 8D, the conductive vias FVa, FVb, FVc, BVa, and BVb having different lengths may be arranged on a conductive pattern. For another example, as illustrated in FIG. 8E, the conductive vias FVa, FVb, FVc, BVa, and BVb having a bar shape may be arranged in different directions.

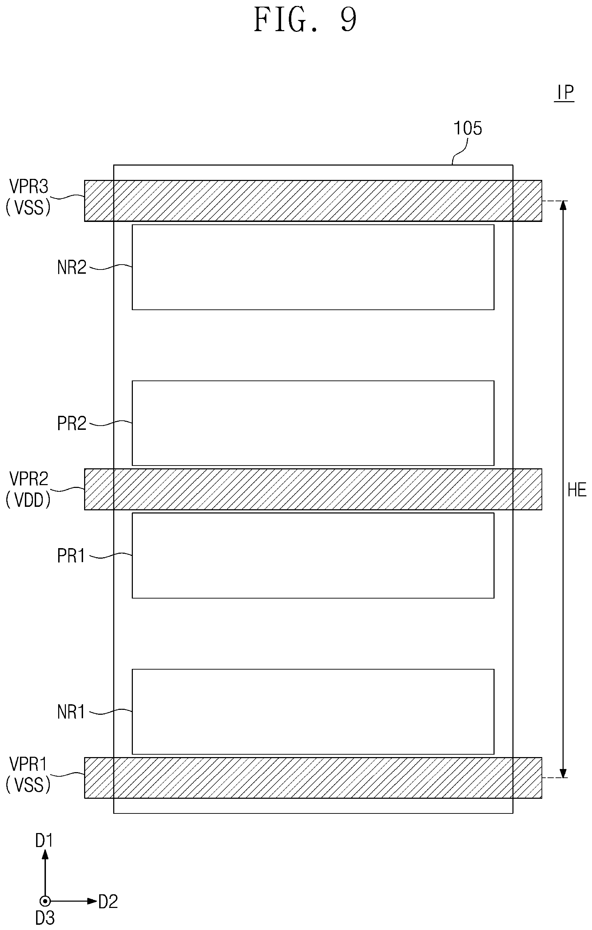

FIG. 9 is a schematic plan view of a logic block provided to a portion of a semiconductor device according to example embodiments of the inventive concept.

Referring to FIG. 9, a first lower power line VPR1, a second lower power line VPR2, and a third lower power line VPR3 may be provided on the substrate 105. The second lower power line VPR2 may be disposed between the first lower power line VPR1 and the third lower power line VPR3.

The substrate 105 of the logic block IP may include a first PMOSFET region PR1, a second PMOSFET region PR2, a first NMOSFET region NR1, and a second NMOSFET region NR2.

The first NMOSFET region NR1 may be adjacent to the first lower power line VPR1. The second NMOSFET region NR2 may be adjacent to the third lower power line VPR3. The first and second PMOSFET regions PR1 and PR2 may be adjacent to the second lower power line VPR2. In a plan view, the second lower power line VPR2 may be disposed between the first and second PMOSFET regions PR1 and PR2.

A length of the logic block IP in the first direction D1 may be defined as a first height HE. The first height HE may be about two times a distance (e.g., pitch) between the first lower power line VPR1 and the second lower power line VPR2. The first and second PMOSFET regions PR1 and PR2 of the logic block IP may be combined and operated as a single PMOSFET region.

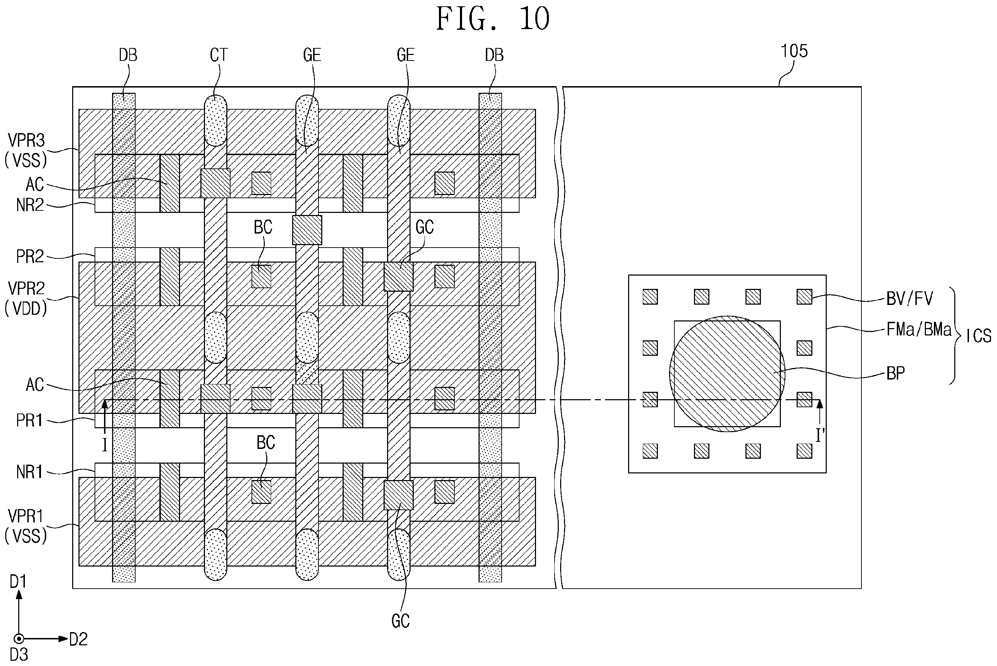

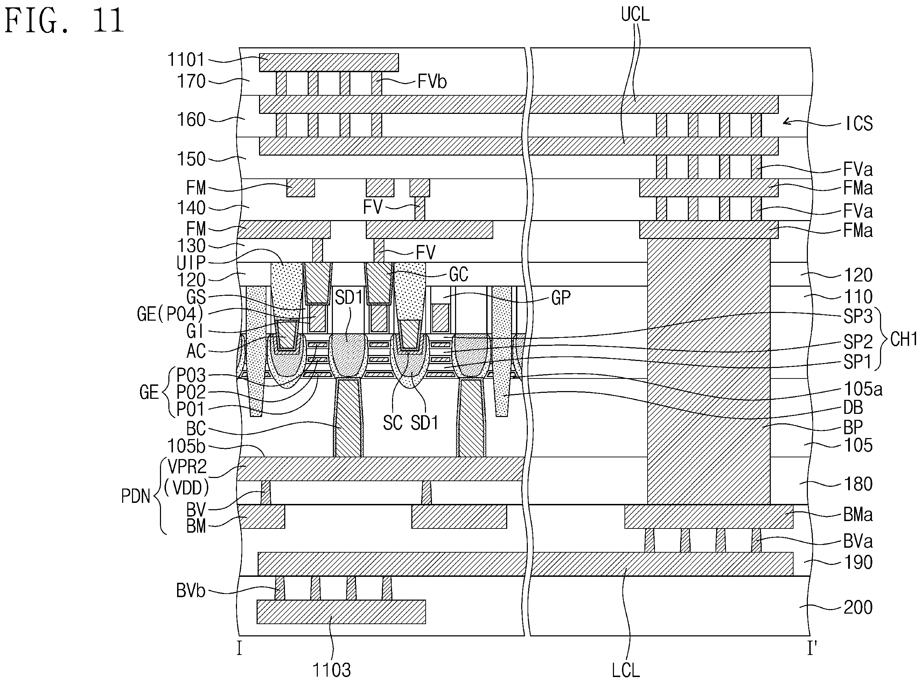

FIG. 10 is a plan view of a portion of a semiconductor device according to example embodiments of the inventive concept. FIG. 11 is a cross-sectional view, taken along line I-I' of FIG. 10, for describing a semiconductor device according to example embodiments of the inventive concept.

Referring to FIGS. 10 and 11, logic transistors constituting the logic block IP may be arranged on the substrate 105. The substrate 105 may include a silicon-based insulating layer. In other words, the substrate 105 may be an insulating substrate. For example, the substrate 105 may include a silicon oxide layer, a silicon nitride layer, or a silicon oxynitride layer.

The substrate 105 may have the first PMOSFET region PR1, the second PMOSFET region PR2, the first NMOSFET region NR1, and the second NMOSFET region NR2. The first PMOSFET region PR1, the second PMOSFET region PR2, the first NMOSFET region NR1, and the second NMOSFET region NR2 may each extend lengthwise in the second direction D2.

First and second insulating patterns (or active patterns) extending lengthwise in the second direction D2 may be defined on the substrate 105. The first and second insulating patterns may be vertically protruding portions of the substrate 105. The first insulating pattern may be provided on each of the first and second PMOSFET regions PR1 and PR2. The second insulating pattern may be provided on each of the first and second NMOSFET regions NR1 and NR2.

First channel patterns CH1 may be respectively provided on the first and second PMOSFET regions PR1 and PR2, and second channel patterns may be respectively provided on the first and second NMOSFET regions NR1 and NR2.

The first channel pattern CH1 and the second channel pattern each may include a first semiconductor pattern SP1, a second semiconductor pattern SP2, and a third semiconductor pattern SP3 sequentially stacked. The first to third semiconductor patterns SP1 to SP3 may be spaced apart from each other in a vertical direction (i.e., third direction D3).

The first to third semiconductor patterns SP1 to SP3 may each include silicon (Si), germanium (Ge), or silicon-germanium (SiGe). For example, the first to third semiconductor patterns SP1 to SP3 may each include crystalline silicon. The first to third semiconductor patterns SP1 to SP3 may each be a nanosheet.

First source/drain patterns SD1 may be provided on both sides of the first channel pattern CH1. The first source/drain patterns SD1 may be impurity regions of a first-conductive type (e.g., p type). The first channel pattern CH1 may be interposed between a pair of the first source/drain patterns SD1. In other words, the stacked first to third semiconductor patterns SP1 to SP3 may connect a pair of the first source/drain patterns SD1 to each other.

Second source/drain patterns may be provided on both sides of the second channel patterns provided on the first and second NMOSFET regions NR1 and NR2. The second source/drain patterns may be impurity regions of a second-conductive type (e.g., n type). The second channel pattern may be interposed between a pair of the second source/drain patterns. In other words, the stacked first to third semiconductor patterns SP1 to SP3 may connect a pair of the second source/drain patterns to each other.

The first source/drain patterns SD1 may be epitaxial patterns formed through a selective epitaxial growth (SEG) process. For example, an upper surface of each of the first source/drain patterns SD1 may be located at substantially the same level as an upper surface of the third semiconductor pattern SP3. For another example, the upper surface of each of the first source/drain patterns SD1 may be higher than the upper surface of the third semiconductor pattern SP3. Likewise, the second source/drain patterns may also be epitaxial patterns.

The first source/drain pattern SD1 may further include an n-type dopant (e.g., phosphorus, arsenic, or antimony). The first source/drain patterns SD1 may include a semiconductor element (e.g., SiGe) having a larger lattice constant than a lattice constant of a semiconductor element of the first channel pattern CH1. Therefore, a pair of the first source/drain patterns SD1 may provide a compressive stress to the first channel pattern CH1 between the first source/drain patterns SD1. The second source/drain patterns provided on the first and second NMOSFET regions NR1 and NR2 may include the same semiconductor element (e.g., Si) as the second channel pattern.

The second source/drain patterns may each include silicon (Si). The second source/drain pattern may further include an n-type dopant (e.g., phosphorus, arsenic, or antimony).

The gate electrodes GE extending lengthwise in the first direction D1 across the first channel patterns CH1 and the second channel patterns (not shown) may be provided. The gate electrodes GE may be arranged in the second direction D2 at a first pitch.

The gate electrode GE may include a first inner electrode PO1 interposed between the substrate 105 and the first semiconductor pattern SP1, a second inner electrode PO2 interposed between the first semiconductor pattern SP1 and the second semiconductor pattern SP2, a third inner electrode PO3 interposed between the second semiconductor pattern SP2 and the third semiconductor pattern SP3, and an outer electrode PO4 on the third semiconductor pattern SP3.

The gate electrode GE may be provided on an upper surface, a bottom surface, and both sidewalls of each of the first to third semiconductor patterns SP1 to SP3. In other words, a transistor according to the present embodiment may be a three-dimensional field effect transistor (e.g., MBCFET or GAAFET) in which the gate electrode GE three-dimensionally surrounds a channel.

Gate cutting patterns CT may be arranged on the gate electrodes GE so as to overlap the gate electrodes GE, respectively. The gate cutting patterns CT may include an insulating material such as silicon oxide, silicon nitride, or a combination thereof.

The gate electrodes GE may be separated from each other in the first direction D1 by the gate cutting pattern CT. In other words, the gate electrode GE extending in the first direction D1 may be separated into a plurality of gate electrodes GE by the gate cutting patterns CT.

A pair of gate spacers GS may be arranged on both sidewalls of the outer electrode PO4 of the gate electrode GE. The gate spacers GS may extend lengthwise in the first direction D1 along the gate electrode GE. Upper surfaces of the gate spacers GS may be higher than an upper surface of the gate electrode GE. The upper surfaces of the gate spacers GS may be coplanar with an upper surface of a first interlayer insulating layer 110 that will be described later. The gate spacers GS may include at least one of SiCN, SiCON, or SiN. For another example, the gate spacers GS may include a multi-layer formed of at least two of SiCN, SiCON, and SiN.

A gate capping pattern GP may be provided on the gate electrode GE. The gate capping pattern GP may extend lengthwise in the first direction D1 along the gate electrode GE. The gate capping pattern GP may include a material having etch selectivity with respect to first and second interlayer insulating layers 110 and 120 that will be described later. In detail, the gate capping pattern GP may include at least one of SiON, SiCN, SiCON, or SiN.

A gate insulating layer GI may be interposed between the gate electrode GE and the first channel pattern CH1 and between the gate electrode GE and the second channel pattern (not shown). The gate insulating layer GI may cover an upper surface, a bottom surface, and both sidewalls of each of the first to third semiconductor patterns SP1 to SP3.

The gate insulating layer GI may include a silicon oxide layer, a silicon oxynitride layer, and/or a high-k layer. The high-k layer may include a high-k material having a higher dielectric constant than a silicon oxide layer. For example, the high-k material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The gate electrode GE may include a first metal pattern and a second metal pattern on the first metal pattern. The first metal pattern may be provided on the gate insulating layer GI and may be adjacent to the first to third semiconductor patterns SP1 to SP3. The first metal pattern may include a work-function metal that adjusts a threshold voltage of a transistor. A desired threshold voltage of a transistor may be achieved by adjusting a thickness and composition of the first metal pattern. For example, the first to third inner electrodes PO1 to PO3 of the gate electrode GE may be configured with a first metal pattern that is a work-function metal.

The first metal pattern may include a metal nitride layer. For example, the first metal pattern may include nitrogen (N) and at least one metal selected from the group consisting of titanium (Ti), tantalum (Ta), aluminum (Al), tungsten (W), and molybdenum (Mo). Furthermore, the first metal pattern may further include carbon (C). The first metal pattern may include a plurality of stacked work-function metal layers.

The second metal pattern may include metal having lower resistance than the first metal pattern. For example, the second metal pattern may include at least one metal selected from the group consisting of tungsten (W), aluminum (Al), titanium (Ti), and tantalum (Ta). For example, the outer electrode PO4 of the gate electrode GE may include the first metal pattern and the second metal pattern on the first metal pattern.

The first interlayer insulating layer 110 may be provided on the substrate 105. The first interlayer insulating layer 110 may contact an upper surface of the substrate 105. The first interlayer insulating layer 110 may cover the gate spacers GS, the first source/drain patterns SD1, and the second source/drain patterns. An upper surface of the first interlayer insulating layer 110 may be substantially coplanar with an upper surface of the gate capping pattern GP and an upper surface of the gate spacer GS. The second interlayer insulating layer 120 covering the gate capping pattern GP may be disposed on the first interlayer insulating layer 110. The second interlayer insulating layer 120 may contact an upper surface of the first interlayer insulating layer 110. Third, fourth, fifth, sixth, and seventh interlayer insulating layers 130, 140, 150, 160, and 170 may be provided on the second interlayer insulating layer 120. A stacked number of the interlayer insulating layers and a stacked number of the upper wiring lines FM and upper conductive vias FV connected to the logic block IP may be variously changed. For example, each of the first to seventh interlayer insulating layers 110 to 170 may include a silicon oxide layer.

A pair of isolation structures DB may face each other in the second direction D2 and may extend in parallel with the gate electrodes GE in the first direction D1. A pitch between the isolation structure DB and the gate electrode GE adjacent thereto may be equal to the first pitch.

The isolation structure DB may penetrate the gate capping pattern GP and the gate electrode GE and extend into the substrate 105. The isolation structure DB may penetrate an upper portion of the substrate 105.

The active contacts AC penetrating the first and second interlayer insulating layers 110 and 120 and electrically connected to the first and second source/drain patterns SD1, respectively may be provided. The active contacts AC may each be provided so as to be adjacent to one side of the gate electrode GE. In a plan view, the active contact AC may have a bar shape extending in the first direction D1.

The active contact AC may be a self-aligned contact. In other words, the active contact AC may be formed in a self-alignment manner using the gate capping pattern GP and the gate spacer GS. For example, the active contact AC may cover at least a portion of a sidewall of the gate spacer GS. Although not illustrated, the active contact AC may cover a portion of an upper surface of the gate capping pattern GP.

A metal-semiconductor compound layer SC, for example, a silicide layer may be interposed between the active contact AC and the first source/drain pattern SD1 and between the active contact AC and the second source/drain pattern. The active contact AC may be electrically connected to the first source/drain pattern SD1 through the metal-semiconductor compound layer SC. For example, the metal-semiconductor compound layer SC may include at least one of titanium-silicide, tantalum-silicide, tungsten-silicide, nickel-silicide, or cobalt-silicide.

Gate contacts GC penetrating the second interlayer insulating layer 120 and the gate capping pattern GP and electrically connected to the gate electrodes GE, respectively may be provided. Upper surfaces of gate contacts GC may be coplanar with an upper surface of the second interlayer insulating layer 120. In a plan view, two gate contacts GC may be arranged on the first PMOSFET region PR1 so as to overlap the first PMOSFET PR1. The gate contact GC may be freely disposed on the gate electrode GE without being limited in terms of a location.

An upper portion of the active contact AC adjacent to the gate contact GC may be filled with an upper insulating pattern UIP. A bottom surface of the upper insulating pattern UIP may be lower than a bottom surface of the gate contact GC. In other words, an upper surface of the active contact AC adjacent to the gate contact GC may be lower than the bottom surface of the gate contact GC due to the upper insulating pattern UIP. Therefore, a short circuit that may occur due to a contact between the gate contact GC and the active contact AC adjacent thereto may be prevented. For example, the upper insulating pattern UIP may include a silicon-based insulating material (e.g., silicon oxide, silicon nitride, or silicon oxynitride).

The active contact AC and the gate contact GC may each include a conductive pattern and a barrier metal pattern surrounding the conductive pattern. For example, the conductive pattern may include at least one metal among aluminum, copper, tungsten, molybdenum, and cobalt. The barrier metal pattern may cover a bottom surface and sidewalls of the conductive pattern. The barrier metal pattern may include a metal layer/metal nitride layer. The metal layer may include at least one of titanium, tantalum, tungsten, nickel, cobalt, and platinum. The metal nitride layer may include at least one of titanium nitride (TiN), tantalum nitride (TaN), tungsten nitride (WN), nickel nitride (NiN), cobalt nitride (CoN), or platinum nitride (PtN).

The power delivery network PDN may be provided on the second surface 105b of the substrate 105. The power delivery network PDN may include the first to third lower power lines VPR1, VPR2, and VPR3 and a plurality of backside wiring lines BM and backside conductive vias BV electrically connected to the first to third lower power lines VPR1 to VPR3.

The first to third lower power lines VPR1 to VPR3 may extend lengthwise in parallel with each other in the second direction D2. The first lower power line VPR1 may vertically overlap the first NMOSFET region NR1. The second lower power line VPR2 may vertically overlap the first PMOSFET region PR1 and the second PMOSFET region PR2. The third lower power line VPR3 may vertically overlap the second NMOSFET region NR2.

The first to third lower power lines VPR1 to VPR3 may include at least one selected from the group consisting of copper, molybdenum, tungsten, and ruthenium. A bottom surface of each of the first to third lower power lines VPR1 to VPR3 may be coplanar with a bottom surface of the substrate 105.

The first and third lower power lines VPR1 and VPR3 may be a passage through which a source voltage such as a ground voltage VSS is provided. The second lower power line VPR2 may be a passage through which a drain voltage such as a power voltage VDD is provided.

The backside contact BC penetrating the substrate 105 and vertically extending from the second lower power line VPR2 to the first source/drain pattern SD1 may be provided.

The backside contact BC may have a conductive pillar shape vertically and electrically connecting the second lower power line VPR2 and the first source/drain pattern SD1. The power voltage VDD may be applied to the first source/drain pattern SD1 through the backside contact BC. The backside contact BC may include, for example, at least one metal selected from the group consisting of tungsten, molybdenum, ruthenium, cobalt, aluminum, and copper.

First and second backside insulating layers 180 and 190 may be sequentially stacked on the second surface 105b of the substrate 105, and the backside wiring lines BM may be provided in the first and second backside insulating layers 180 and 190.

According to embodiments, the through conductive pattern BP may be spaced apart from the logic block IP and penetrate the substrate 105 in the third direction D3. A vertical length of the through conductive pattern BP may be larger than a vertical length of the backside contact BC. For example, the through conductive pattern BP may penetrate the first and second interlayer insulating layers 110 and 120 and the first backside insulating layer 180.

The through conductive pattern BP may have a circular column, quadrilateral column, or polygonal column shape. In the second direction D2, a width of the through conductive pattern BP may be larger than a width of the backside contact BC. The through conductive pattern BP may include, for example, at least one metal among copper, aluminum, tungsten, molybdenum, and cobalt. Furthermore, the through conductive pattern BP may further include a metal nitride layer (not shown) covering sidewalls thereof. For example, the metal nitride layer may include at least one of titanium nitride (TiN), tantalum nitride (TaN), tungsten nitride (WN), nickel nitride (NiN), cobalt nitride (CoN), or platinum nitride (PtN).

The first upper conductive patterns FMa and the first upper conductive vias FVa may be alternately stacked on an upper surface of the through conductive pattern BP. The upper connection lines UCL may be stacked on the uppermost first upper conductive vias FVa. For example, the upper connection lines UCL may be arranged in the fifth and sixth interlayer insulating layers 150 and 160. The upper connection lines UCL may extend lengthwise in the second direction D2 and may vertically overlap the upper chip pad 1101 the through conductive pattern BP.

The second upper conductive via FVb may be connected between the uppermost upper connection lines UCL and the upper chip pad 1101. Furthermore, one or more second upper conductive patterns may be further arranged between the second upper conductive via FVb and the upper chip pad 1101.

The first lower conductive pattern BMa and the first lower conductive vias BVa may be sequentially stacked on a lower surface of the through conductive pattern BP.

At least one lower connection line LCL may be provided on the first lower conductive vias BVa. The lower connection line LCL may be disposed in the second backside interlayer insulating layer 190 and connected to the lower conductive pattern BMa through the first lower conductive vias BVa. The lower connection line LCL may have a bar shape having a long axis in the second direction D2. The lower connection line LCL may be connected to the lower chip pad 1103 through the second lower conductive vias BVb in a third backside interlayer insulating layer 200.

According to embodiments, the connection structure ICS may detour around the logic block IP and electrically connect the upper chip pad 1101 and the lower chip pad 1103. Therefore, the degree of freedom of design and the degree of integration of a semiconductor device may be improved.

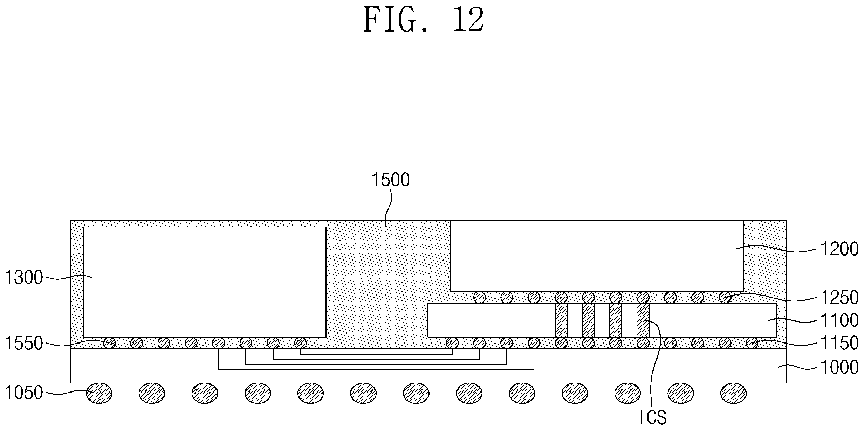

FIG. 12 is a cross-sectional view of a semiconductor package including a semiconductor device according to example embodiments of the inventive concept.

Referring to FIG. 12, a semiconductor package may include the redistribution substrate 1000, the first semiconductor device 1100, the second semiconductor device 1200, and a third semiconductor device 1300. The first semiconductor device 1100 and the third semiconductor device 1300 may be mounted on the redistribution substrate 1000, and the second semiconductor device 1200 may be mounted on the first semiconductor device 1100.

In an embodiment, the redistribution substrate 1000, the first semiconductor device 1100, and the second semiconductor device 1200 may include substantially the same components as the embodiment described above with reference to FIG. 1. For example, the first semiconductor device 1100 may include the connection structures ICS described above, and the second semiconductor device 1200 may be electrically connected to the redistribution substrate 1000 through the connection structures ICS.

The first connection terminals 1050 may be attached to a lower portion of the redistribution substrate 1000, and the second connection terminals 1150 may be attached to an upper portion of the redistribution substrate 1000. Furthermore, the third connection terminals 1250 may be connected between the first semiconductor device 1100 and the second semiconductor device 1200. The first, second, and third connection terminals 1050, 1150, and 1250 may be at least one of a solder ball, a conductive bump, or a conductive pillar. The first, second, and third connection terminals 1050, 1150, and 1250 may include, for example, at least one of copper, tin, or lead.

The semiconductor package may transmit/receive signals to/from external other packages or other semiconductor devices through the first connection terminals 1050. For example, a power (ground or power supply) signal for driving the first and second semiconductor devices 1100 and 1200 may be received through at least some of the first connection terminals 1050 of the redistribution substrate 1000.

The redistribution substrate 1000 may connect the first semiconductor device 1100 and the third semiconductor device 1300. The redistribution substrate 1000 may provide physical paths that connect the first semiconductor device 1100 and the third semiconductor device 1300 and are formed using conductive materials. Accordingly, the first semiconductor device 1100 and the third semiconductor device 1300 may be mounted on the redistribution substrate 1000 and exchange signals with each other.

The second semiconductor device 1200 may execute applications supported by the semiconductor package using the first semiconductor device 1100. For example, the second semiconductor device 1200 may include at least one processor among a central processing unit (CPU), an application processor (AP), a graphic processing unit (GPU), a neural processing unit (NPU), a tensor processing unit (TPU), a vision processing unit (VPU), an image signal processor (ISP), and a digital signal processor (DSP) and may perform specialized operations.

For example, the second semiconductor device 1200 may include a physical layer and a memory controller. The physical layer may include input/output circuits for transmitting/receiving signals to/from a physical layer of the first semiconductor device 1100.

The third semiconductor device 1300 may be disposed horizontally side-by-side with the first semiconductor device 1100 on the redistribution substrate 1000. The third semiconductor device 1300 may include a memory chip. For example, the memory chip may include a DRAM, SRAM, MRAM, and/or NAND flash memory.

Fourth connection terminals 1550 may be arranged between the third semiconductor device 1300 and the redistribution substrate 1000. The third semiconductor device 1300 may be electrically connected to the redistribution substrate 1000 through the fourth connection terminals 1550. The fourth connection terminals 1550 may connect chip pads of the third semiconductor device 1300 and upper connection pads of the redistribution substrate 1000. Furthermore, the third semiconductor device 1300 may be electrically connected to the first semiconductor device 1100 and the second semiconductor device 1200 through redistribution lines in the redistribution substrate 1000.

The semiconductor package may further include a molding layer 1500 covering side surfaces of the first, second, and third semiconductor devices 1100, 1200, and 1300 and an upper surface of the redistribution substrate 1000. A side surface of the molding layer 1500 may be substantially coplanar with a side surface of the redistribution substrate 1000. The molding layer 1500 may include, for example, an epoxy mold compound (EMC).

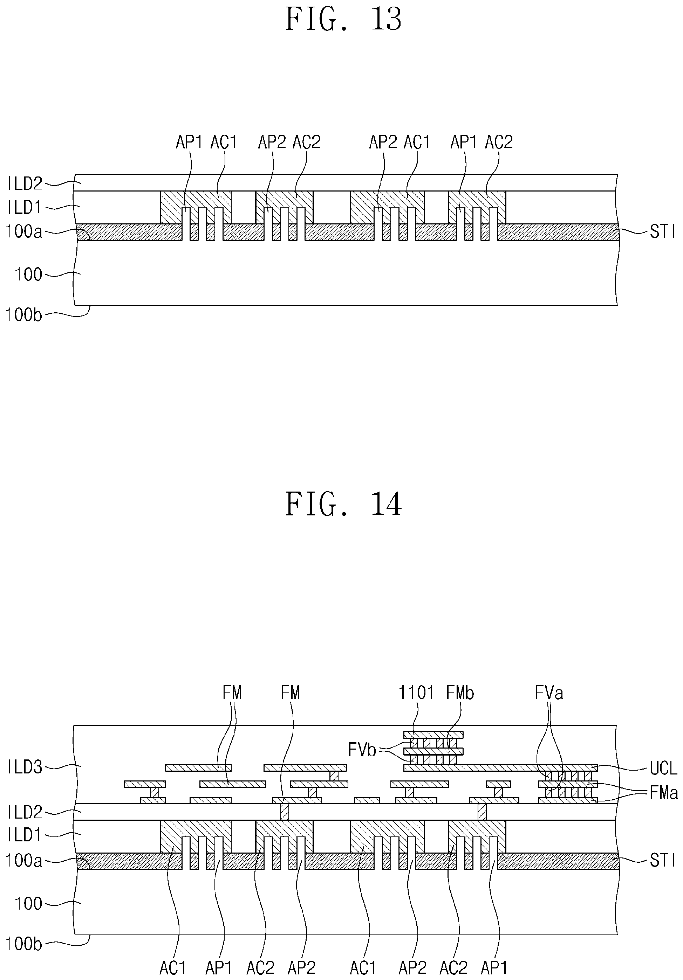

FIGS. 13 to 17 are diagrams illustrating a method for manufacturing a semiconductor package according to example embodiments of the inventive concept.

Referring to FIG. 13, a first semiconductor substrate 100 may be provided. The first semiconductor substrate 100 may be a silicon substrate, for example. The first semiconductor substrate 100 may have a first surface 100a and a second surface 100b opposite the first surface 100a.

First and second active patterns AP1 and AP2 may be formed on the first surface 100a of the first semiconductor substrate 100. The first and second active patterns AP1 and AP2 may have linear shapes extending lengthwise side-by-side in the first direction D1. The first and second active patterns AP1 and AP2 may be formed by forming trenches by patterning the first semiconductor substrate 100. The first and second active patterns AP1 and AP2 may be portions of the first semiconductor substrate 100 and may be defined by trenches formed in the first semiconductor substrate 100.

A device isolation layer STI may be formed between the first and second active patterns AP1 and AP2. For example, the device isolation layer STI may contact side surfaces of the first and second active patterns AP1 and AP2. An upper surface of the device isolation layer STI may be located below upper surfaces of the first and second active patterns AP1 and AP2 so that upper portions of the first and second active patterns AP1 and AP2 may be exposed.

The gate electrode GE (see FIG. 11) and active contacts AC1 and AC2 may be formed. The active contacts AC1 and AC2 may be in contact with the first and second active patterns AP1 and AP2. The active contacts AC1 and AC2 may each include a barrier metal layer and a metal layer.

A first interlayer insulating layer ILD1 may be provided on the substrate 105. The first interlayer insulating layer ILD1 may cover the gate spacers GS, the first source/drain patterns SD1, and the second source/drain patterns. A second interlayer insulating layer ILD2 may be stacked on the first interlayer insulating layer ILD1.

Referring to FIG. 14, the upper wiring lines FM may be stacked on the second interlayer insulating layer ILD2. The upper wiring lines FM may be formed in a third interlayer insulating layer ILD3 including a plurality of insulating layers. The upper wiring lines FM stacked vertically may be electrically connected through contact plugs, and may be connected to a logic block (i.e., gate electrodes and active contacts).

The first upper conductive patterns FMa, the first upper conductive vias FVa, the upper connection lines UCL, the second upper conductive patterns FMb, and the second upper conductive vias FVb may be formed while the upper wiring lines FM connected to the logic block is being formed.

The upper chip pad 1101 may be formed in an uppermost interlayer insulating layer. The upper chip pad 1101 may be electrically connected to the first upper conductive patterns FMa, the upper connection lines UCL, and the second upper conductive patterns FMb through conductive vias. The upper chip pad 1101 may include, for example, at least one of copper, aluminum, tungsten, nickel, gold, tin, titanium, or an alloy thereof. The upper chip pad 1101 may be formed by performing an electroplating process after forming a seed metal layer.

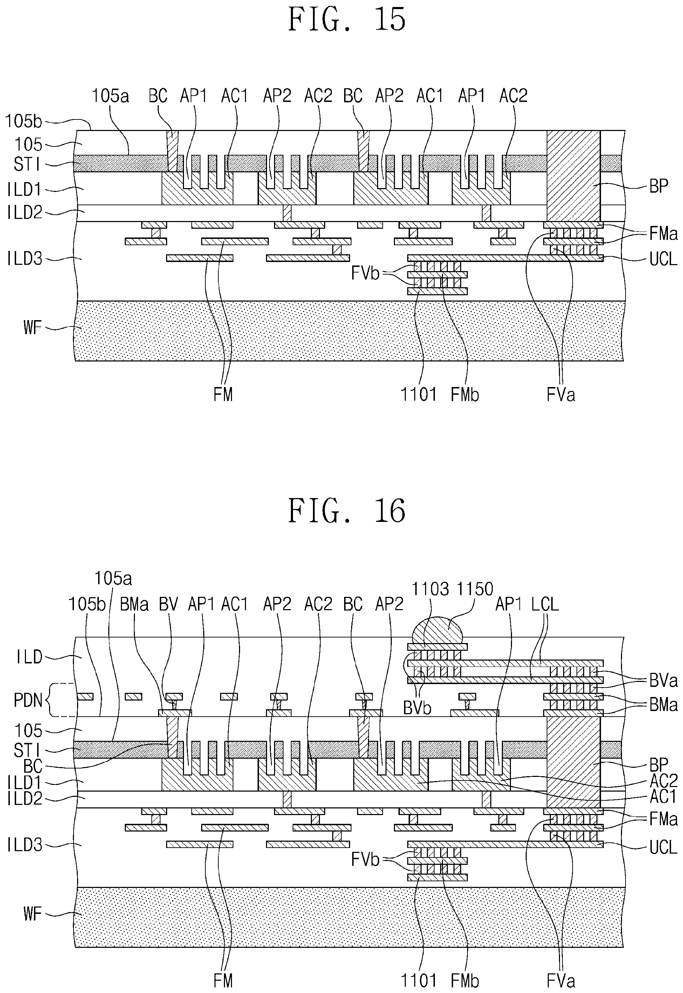

Referring to FIG. 15, a thinning process for reducing a thickness of the first semiconductor substrate 100 may be performed after forming the upper chip pad 1101. The thinning process includes grinding or polishing the second surface 100b of the first semiconductor substrate 100 and isotropically and anisotropically etching the same.

A second semiconductor substrate WF may be attached on the uppermost interlayer insulating layer ILD3 using an adhesive layer in order to thin the first semiconductor substrate 100. The first semiconductor substrate 100 may be turned upside down after the second semiconductor substrate WF is attached. A portion of the first semiconductor substrate 100 may be removed through a grinding or polishing process, and, thereafter, remaining surface defects of the first semiconductor substrate 100 may be removed by performing an anisotropic or isotropic etching process.

Thereafter, a process may be performed to replace the first semiconductor substrate 100 with the substrate 105 formed of an insulating material. The substrate 105 may include the first and second active patterns AP1 and AP2 like the first semiconductor substrate 100. Furthermore, the substrate 105 may have the first surface 105a that is in contact with the device isolation layer STI and the second surface 105b opposite to the first surface 105a.

Thereafter, through-holes that expose at least one of the active contacts AC1 and AC2 or source/drain patterns may be formed by patterning the second surface 105b of the substrate 105. A vertical length of the through-holes may be about 1 µm or less. Thereafter, a metal material is buried in the through-holes, and then the backside contacts BC may be formed by planarizing the metal material so that the second surface 105b of the substrate 105 is exposed.

The through conductive pattern BP penetrating the substrate 105 may be formed after the backside contacts BC are formed. The through conductive pattern BP may be formed by forming through-holes that expose the first upper conductive pattern FMa by partially patterning the interlayer insulating layers ILD1 and ILD2 and the second surface 105b of the substrate 105, and then by burying a metal material in the through-holes and planarizing the metal material so that the second surface 105b of the substrate 105 is exposed.

Referring to FIG. 16, the power delivery network PDN may be formed on the second surface 105b of the substrate 105 after the through conductive pattern BP is formed. Forming of the power delivery network PDN may include forming power lines or backside wiring lines BM with backside insulating layers ILD interposed therebetween. Furthermore, when forming the backside wiring lines BM, the first lower conductive patterns BMa and the lower connection lines LCL may be formed on the through conductive pattern BP.

The lower chip pad 1103 may be formed at an uppermost metal layer in the backside insulating layers ILD. The uppermost backside insulating layer ILD may include a plurality of openings for soldering the second connection terminal 1150 and the lower chip pad 1103. The lower chip pad 1103 may be electrically connected to the through conductive pattern BP through the lower connection lines LCL, the first lower conductive patterns BMa, and the lower conductive vias BVa and BVb.

Thereafter, the second connection terminal 1150 may be attached to the lower chip pad 1103. The lower chip pad 1103 may include at least one of copper, nickel, zinc, gold, silver, platinum, palladium, chromium, titanium, or an alloy thereof. The second connection terminals 1150 may include at least one of tin, silver, lead, nickel, copper, or an alloy thereof.

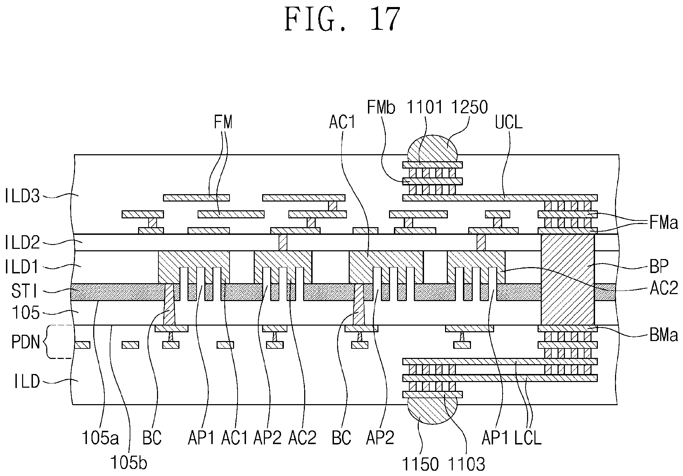

Referring to FIG. 17, the third connection terminal 1250 may be attached to the upper chip pad 1101 after removing the second semiconductor substrate WF on the uppermost interlayer insulating layer ILD3. The uppermost interlayer insulating layer ILD3 may include a plurality of openings for soldering the third connection terminal 1250 and the upper chip pad 1101. The third connection terminals 1250 may include at least one of tin, silver, lead, nickel, copper, or an alloy thereof.

According to embodiments of the inventive concept, a connection structure connecting a redistribution substrate and an upper semiconductor device may be formed using upper wiring lines connected to logic blocks on a first surface of a substrate and backside wiring lines connected to the logic blocks on a second surface of the substrate. Accordingly, the connection structure that detours around the logic blocks may be provided without changing a design of the logic blocks provided in a semiconductor device. Therefore, the degree of freedom of design and the degree of integration of a semiconductor device may be improved.

Although the embodiments of the present invention have been described, it is understood that the present invention should not be limited to these embodiments but various changes and modifications can be made by one ordinary skilled in the art within the scope of the present invention as hereinafter claimed.

Embodiments are set out in the following clauses:
Clause 1. A semiconductor package comprising:
   a redistribution substrate;
   a first semiconductor chip on the redistribution substrate; and
   a second semiconductor chip on the first semiconductor chip,
   wherein the first semiconductor chip includes:
      upper chip pads provided on an upper surface of the first semiconductor chip;
      lower chip pads provided on a lower surface of the first semiconductor chip;
      a logic block provided on a first surface of a substrate;
      an upper wiring line connected to the logic block on the first surface of the substrate;
      a power delivery network provided on a second surface of the substrate and including power lines connected to the logic block; and
      a connection structure penetrating the substrate and connecting a first upper chip pad among the upper chip pads and a first lower chip pad among the lower chip pads,
   wherein the connection structure includes:
      a through conductive pattern horizontally spaced apart from the logic block and penetrating the substrate;
      upper connection lines connecting the through conductive pattern and the first upper chip pad on the first surface of the substrate; and
      lower connection lines connecting the through conductive pattern and the first lower chip pad on the second surface of the substrate, and
   wherein the first upper chip pad and the first lower chip pad vertically overlap the logic block.
Clause 2. The semiconductor package of clause 1,
   wherein some of the upper connection lines are located at a farther distance from the first surface than the upper wiring line, and
   wherein some of the lower connection lines are located at a farther distance from the second surface than the power lines.
Clause 3. The semiconductor package of clause 1 or clause 2, wherein the logic block includes:
   source and drain patterns;
   a channel pattern between the source and drain patterns, the channel pattern including a plurality of semiconductor patterns stacked and spaced apart from each other;
   a gate electrode on the channel pattern;
   an active contact on the source and drain patterns and connected to one of the source and drain patterns;
   upper wiring lines connected to the active contact; and
   a backside contact connecting the other one of the source and drain patterns and one of the power lines under the source and drain patterns.
Clause 4. The semiconductor package of any of clauses 1-3, further comprising:
   first connection terminals connected between the redistribution substrate and the lower chip pads of the first semiconductor chip; and
   second connection terminals connected between the second semiconductor chip and the upper chip pads of the first semiconductor chip.
Clause 5. The semiconductor package of clause 4, wherein a width of each of the first connection terminals is larger than a width of each of the second connection terminals.

## Claims

1. A semiconductor device (1100) comprising:
a substrate (105) having a first surface (105a) and a second surface (105b) opposite each other;
a logic block (IP) provided on the first surface (105a) of the substrate (105);
a power delivery network (PDN) including power lines (BM) connected to the logic block (IP) on the second surface (105b) of the substrate (105); and
a connection structure (ICS) penetrating the substrate (105) and connecting an upper chip pad (1101) and a lower chip pad (1103),
wherein at least one of the upper chip pad (1101) or the lower chip pad (1103) vertically overlaps the logic block (IP), and
wherein the connection structure (ICS) includes a through conductive pattern (BP) penetrating the substrate (105), the through conductive pattern (BP) horizontally spaced apart from the logic block (IP).

2. The semiconductor device (1100) of claim 1,
wherein the connection structure (ICS) further includes:
upper connection lines (UCL) connecting the through conductive pattern (BP) and the upper chip pad (1101) on the first surface (105a) of the substrate (105); and
lower connection lines (LCL) connecting the through conductive pattern (BP) and the lower chip pad (1103) on the second surface (105b) of the substrate (105), and
wherein the upper connection lines (UCL) vertically overlap the through conductive pattern (BP) and the logic block (IP).

3. The semiconductor device (1100) of claim 2, wherein the lower connection lines (LCL) overlap the through conductive pattern (BP) and the logic block (IP).

4. The semiconductor device (1100) of claim 2 or claim 3, wherein the connection structure (ICS) further includes:
first upper conductive patterns (FMa) and first upper conductive vias (FVa) alternately stacked between the through conductive pattern (BP) and the upper connection lines (UCL);
second upper conductive patterns (FMb) and second upper conductive vias (FVb) alternately stacked between the upper chip pad (1101) and the upper connection lines (UCL);
first lower conductive patterns (BMa) and first lower conductive vias (BVa) alternately stacked between the through conductive pattern (BP) and the lower connection lines (LCL); and
second lower conductive patterns (BMb) and second lower conductive vias (BMb) alternately stacked between the lower chip pad (1103) and the lower connection lines (LCL).

5. The semiconductor device (1100) of claim 4, further comprising:
upper wiring lines (FM) connected to the logic block (IP) on the first surface (105a),
wherein the first upper conductive patterns (FMa) are located at substantially the same level as the upper wiring lines (FM).

6. The semiconductor device (1100) of claim 4 or claim 5, wherein the first lower conductive patterns (BMa) are located at substantially the same level as the power lines (BM) of the power delivery network (PDN).

7. The semiconductor device (1100) of any preceding claim, wherein the logic block (IP) includes:
source and drain patterns (SD);
a channel pattern (CH1) between the source and drain patterns (SD), the channel pattern including a plurality of semiconductor patterns (SP1, SP2, SP3) stacked and spaced apart from each other;
a gate electrode (GE) on the channel pattern (CH1);
an active contact (AC) on the source and drain patterns (SD) and connected to one of the source and drain patterns (SD);
upper wiring lines (FM) connected to the active contact (AC); and
a backside contact (BC) connecting the other one of the source and drain patterns (SD) and one of the power lines (BM) under the source and drain patterns (SD).

8. The semiconductor device (1100) of claim 7, wherein a width of the through conductive pattern (BP) is greater than a width of the backside contact (BC).

9. A semiconductor device (1100) comprising:
a substrate (105) having a first surface (105a) and a second surface (105b) opposite each other;
a logic block (IP) provided on the first surface (105a) of the substrate (105);
an upper wiring line (FM) connected to the logic block (IP) on the first surface (105a);
a power delivery network (PDN) including power lines (BM) connected to the logic block (IP) on the second surface (105b); and
a connection structure (ICS) penetrating the substrate (105) and connecting an upper chip pad (1101) and a lower chip pad (1103),
wherein at least one of the upper chip pad (1101) or the lower chip pad (1103) vertically overlaps the logic block (IP), and
wherein the connection structure (ICS) includes:
a through conductive pattern (BP) that is horizontally spaced apart from the logic block (IP) and penetrates the substrate (105);
an upper connection line (UCL) provided on the first surface (105a) and vertically overlapping the through conductive pattern (BP) and the logic block (IP); and
a lower connection line (LCL) provided on the second surface (105b) and vertically overlapping the through conductive pattern (BP) and the logic block (IP).

10. The semiconductor device (1100) of claim 9, wherein the upper chip pad (1101) does not vertically overlap the lower chip pad (1103).

11. The semiconductor device (1100) of claim 9 or claim 10, wherein a length of the upper connection line (UCL) is different from a length of the lower connection line (LCL) in one direction.

12. The semiconductor device (1100) of any of claims 9-11, wherein the connection structure (ICS) further includes upper conductive patterns (FMa) and upper conductive vias (FVa) vertically and alternately stacked between the upper connection line (UCL) and the through conductive pattern (BP).

13. The semiconductor device (1100) of any of claims 9-12, wherein the connection structure (ICS) further includes lower conductive patterns (BMa) and lower conductive vias (BVa) vertically and alternately stacked between the lower connection line (LCL) and the through conductive pattern (BP).

14. The semiconductor device (1100) of any of claims 9-13, wherein the logic block (IP) includes:
source and drain patterns (SD);
a channel pattern (CH1) between the source and drain patterns (SD), the channel pattern (CH1) including a plurality of semiconductor patterns (SP1, SP2, SP3) stacked and spaced apart from each other;
a gate electrode (GE) on the channel pattern (CH1);
an active contact (AC) on the source and drain patterns (SD) and connected to one of the source and drain patterns (SD);
upper wiring lines (UCL) connected to the active contact (AC); and
a backside contact (BC) connecting the other one of the source and drain patterns (SD) and one of the power lines (BM) under the source and drain patterns (SD).

15. The semiconductor device (1100) of claim 14, wherein a width of the through conductive pattern (BP) is larger than a width of the backside contact (BC).
